Europäisches Patentamt

European Patent Office

Office européen des brevets

(11) Veröffentlichungsnummer: **0 289 865**

**A2**

## EUROPÄISCHE PATENTANMELDUNG

(21) Anmeldenummer: 88106300.2

(22) Anmeldetag: 20.04.88

(51) Int. Cl.⁴: **H01L 27/14 , H01L 31/18**

(30) Priorität: 05.05.87 DE 3714920

(43) Veröffentlichungstag der Anmeldung:
09.11.88 Patentblatt 88/45

(84) Benannte Vertragsstaaten:
**DE ES FR GB IT**

(71) Anmelder: **Messerschmitt-Bölkow-Blohm
Gesellschaft mit beschränkter Haftung
Robert-Koch-Strasse
D-8012 Ottobrunn(DE)**

(72) Erfinder: **Thalheimer, Klaus
Buchenweg 7
D-8654 Marktleugast(DE)**

(54) Verfahren zur Herstellung einer Dünnschicht-Solarzellenanordnung.

(57) Bei einem Verfahren zur Herstellung einer Solarzellenanordnung in Reihenschaltung und integrierter Dünnschichttechnik soll auf verfahrenstechnisch möglichst einfache Weise die Verschaltung so zuverlässig und gleichmäßig wie möglich erfolgen. Auf einem transparenten Substrat 1 wird zunächst eine erste, transparente Elektrode 2 großflächig abgeschieden und strukturiert. Sodann werden eine photoempfindliche Halbleiterschicht 4 sowie eine zweite Elektrodenschicht 5 nacheinander großflächig abgeschieden und gemeinsam strukturiert. Danach werden Kontaktelemente 7 unter Ausfüllung der durch die Strukturierung entstandenen Gräben - schichtförmig aufgebracht und neben den genannten Gräben durch weitere Gräben 9 mindestens bis zur Oberfläche der Halbleiterschicht 4 strukturiert, wodurch separate, in Reihe geschaltete Solarzellen 10 entstehen.

FIG. 6

EP 0 289 865 A2

Xerox Copy Centre

## Verfahren zur Herstellung einer Dünnschicht-Solarzellenanordnung

Die Erfindung betrifft ein Verfahren zur Herstellung einer Solarzellenanordnung in Reihenschaltung und integrierter Dünnschichttechnik, gemäß dem Oberbegriff des Patentanspruchs 1.

Ein derartiges Verfahren ist aus der DE-A1 32 10 742 bekannt. Dort wird in einem ersten Verfahrensschritt auf einem Glassubstrat eine als erste Elektrodenschicht dienende, transparente Metallschicht großflächig aufgedampft. Anschließend wird diese erste Elektrodenschicht, vorzugsweise durch Ritzen, in bestimmten Bereichen abgetragen, um so bis auf die Substratoberfläche herabreichende, erste Gräben zu erzeugen. Durch diesen Verfahrensschritt ist bereits die Strukturierung in eine Folge nebeneinander liegender, einzelner Solarzellen vorgegeben. Sodann wird auf die nunmehr getrennten Zonen der ersten Elektrodenschicht eine durchgehende Halbleiterschicht großflächig abgeschieden. Hierbei handelt es sich vorzugsweise um amorphes Silizium, welches beispielsweise eine pin-Schichtstruktur aufweist. Die großflächige Abscheidung der Halbleiterschicht erfolgt im Quasi-Vakuum mit Hilfe eines Glimmentladungsverfahrens aus einer beispielsweise silanhaltigen Gasatmosphäre, siehe etwa die US-PS 4 064 521. Anschließend werden auf der durchgehenden Halbleiterschicht, die intern so strukturiert ist, daß einfallende elektromagnetische Energie, insbesondere in Form von Licht, in elektrische Ladung umgewandelt wird, separate Kontaktelemente aufgebracht, welche später zur Reihenverschaltung der einzelnen Solarzellen dienen sollen. Diese Kontaktelemente, beispielsweise aus Aluminium bestehend, werden mit Hilfe von Maskierungsverfahren oder auf photolithographischem Wege streifenförmig aufgedampft, und zwar in etwa oberhalb der durch die bereichsweise Entfernung der ersten Elektrodenschicht entstandenen Gräben. In einem nächsten Verfahrensschritt wird eine durchgehende, zweite Elektrodenschicht, beipielsweise aus Indiumzinnoxid (ITO) bestehend, über der Halbleiterschicht mit den darauf befindlichen Kontaktelementstreifen aufgedampft. Dies geschieht im allgemeinen ebenfalls im Vakuum. In der so entstandenen Solarzellenanordnung sind die einzelnen Solarzellen noch durch die durchgehende zweite Elektrodenschicht an ihrer Oberseite elektrisch kurzgeschlossen. Um diesen Kurzschluß aufzuheben, wird die zweite Elektrodenschicht sowie die Halbleiterschicht neben den Kontaktelementstreifen bis in die Oberfläche der ersten Elektrodenschicht hinein eingeritzt (zweite Gräben), beispielsweise ebenso wie im Falle der ersten Elektrodenschicht unter Verwendung eines Laserstrahles. Hiermit sind die einzelnen Solarzellen elektrisch nahezu voneinander isoliert. Um eine Reihenverschaltung der Solarzellen untereinander zu bewirken, wird die Anordnung anschließend einer Wärmebehandlung unterzogen, sodaß durch die Erhitzung die metallischen Kontaktelemente dornenartig durch die Halbleiterschicht bis zur Oberfläche der jeweiligen ersten Elektrodenschicht der benachbarten Solarzelle hindurchschmelzen. Somit sind die elektrischen Kontakte zwischen den ersten und zweiten Elektrodenschichten je zweier benachbarter Solarzellen hergestellt.

Dieses bekannte Herstellungsverfahren erweist sich insgesamt als relativ aufwendig. Zwar werden abgesehen von der ersten Elektrodenschicht weitere zwei Schichten, nämlich die Halbleiterschicht sowie die zweite Elektrodenschicht durch Vakuumverfahren großflächig abgeschieden, jedoch sind diese beiden Verfahrensschritte durch einen zwischengeschalteten Verfahrensschritt zur Aufbringung der streifenförmigen, metallischen Kontaktelemente unterbrochen. Dies geschieht unter Anwendung eines Maskierungsverfahrens bzw. auf lithographischem Wege. Diese beiden Verfahrensvarianten sind relativ aufwendig und bedingen eine Unterbrechung des Vakuumprozesses. Weiterhin ist die Herstellung der Reihenverschaltung der einzelnen Solarzellen durch Wärmebehandlung mit einer gewissen Unsicherheit verbunden. Das gleichmäßige Hindurchschmelzen der metallischen Kontaktelemente durch die Halbleiterschicht ist nur schwer zu kontrollieren und die Kontaktierung daher möglicherweise ungleichmäßig.

Der Erfindung liegt daher die Aufgabe zugrunde, ein Verfahren der eingangs genannten Art bereitzustellen, welches verfahrenstechnisch möglichst einfach durchzuführen ist, wobei die Reihenverschaltung der einzelnen Solarzellen so zuverlässig und gleichmäßig wie möglich erfolgen soll.

Diese Aufgabe wird gemäß der Erfindung durch die im kennzeichnenden Teil des Patentanspruchs 1 gegebenen Maßnahmen gelöst.

Demnach wird nunmehr davon Abstand genommen, die Kontaktelemente bereits auf der großflächig abgeschiedenen Halbleiterschicht aufzubringen. Auf diese wird vielmehr sofort anschließend großflächig die zweite Elektrodenschicht aufgebracht. Diese beiden Verfahrensschritte können somit unter Beibehaltung des Vakuums durchgeführt werden. Erst daran anschließend werden in seitlicher Versetzung zu den die erste Elektrodenschicht strukturierenden ersten Gräben zweite Gräben in die beiden großflächig abgeschiedenen Schichten eingebracht, und zwar bis zur Oberfläche der verbleibenden Flächenbereiche der ersten Elektrodenschicht herab. Erst nach diesem an sich bereits aus der DE-A1 32 10 742 bekannten Verfahrensschritt werden die Kontaktelemente aufgebracht, und zwar schichtförmig unter Ausfüllung der zweiten Gräben. Hierdurch werden die durch die zweiten Gräben getrennten Flächenbereiche der zweiten Elektrodenschicht wieder kurzgeschlossen. Daher werden anschließend weitere Gräben, und zwar in seitlicher Versetzung zu den zweiten Gräben und parallel zu diesen, eingebracht, welche mindestens bis zur Oberfläche der Halbleiterschicht hinabreichen und so die schichtförmigen Kontaktelemente voneinander trennen. Damit ist die Reihenverschaltung der einzelnen Solarzellen vollendet.

Durch das erfindungsgemäße Verfahren entsteht ein System von jeweils drei Gräben, welche in seitlicher Versetzung parallel zueinander verlaufen. Die ersten Gräben durchtrennen die erste Elektrodenschicht, die zweiten Gräben die zweite Elektrodenschicht sowie die Halbleiterschicht und die dritten (weiteren) Gräben die schichtförmigen Kontaktelemente sowie die zweite Elektrodenschicht.

Im vorliegenden Zusammenhang ist noch auf die ältere, nicht vorveröffentlichte Deutsche Patentanmeldung P 35 45 385.0-33 hinzuweisen. In dieser ist ebenfalls ein Verfahren zur Herstellung einer Solarzellenanordnung in Reihenschaltung und integrierter Dünnschichttechnik beschrieben. Auch dort werden auf einer durch erste Gräben strukturierten, auf einem Substrat aufgebrachten, ersten Elektrodenschicht nacheinander im Vakuum großflächig eine Halbleiterschicht sowie eine zweite Elektrodenschicht abgeschieden. Anschließend wird die zweite Elektrodenschicht durch Ätzen oder Laserritzen mit Gräben einer gewissen Breite, welche in seitlicher Versetzung in etwa parallel zu den ersten Gräben verlaufen, versehen. In einem weiteren Strukturierungsschritt wird dann ein Teil der nach Einbringung dieser Gräben freigelegten Halbleiterschicht entfernt, beispielsweise durch Anwendung von Ultraschall. Anschließend werden separate Kontaktelemente angebracht, welche jedoch nur die schmaleren Gräben in der Halbleiterschicht ausfüllen. Es muß darauf geachtet werden, daß hierbei kein Kurzschluß zwischen den verbleibenden Bereichen der zweiten Elektrodenschicht entsteht. Daher sind die Gräben in dieser Elektrodenschicht breiter auszuführen als diejenigen in der Halbleiterschicht, und die Kontaktelemente sind mit äußerster Sorgfalt so aufzubringen, daß keine Kurzschlüsse entstehen.

Gegenüber dem eingangs genannten, bekannten Verfahren ist bei dem nicht vorveröffentlichten Verfahren also bereits die Verbesserung vorgenommen worden, daß die Halbleiterschicht und die zweite Elektrodenschicht direkt nacheinander ohne Unterbrechung des Vakuums großflächig abgeschieden werden. Allerdings sind die folgenden Strukturierungs-und Kontaktierungsschritte mit so großer Sorgfalt auszuführen, daß dies wiederum eine Fehlerquelle im Verfahrensablauf darstellt. Auch dieses Verfahren ist demnach noch verbesserungsbedürftig.

Bei dem erfindungsgemäßen Verfahren werden die letzten Strukturierungs-und Kontaktierungsschritte so ausgeführt, daß das Entstehen von Kurzschlüssen zwischen den verbliebenen Flächenbereichen der zweiten Elektrodenschicht ohne weiteres in Kauf genommen wird, sodaß hierdurch schon eine wesentliche Vereinfachung des Verfahrensablaufs eintritt, da die Genauigkeitsanforderungen verringert sind. Die Kontaktelemente werden schichtförmig aufgebracht, und zwar gemäß einer ersten Variante großflächig und gemäß einer zweiten Variante mittels einer Maskierungstechnik bereits in separaten Flächenbereichen unter Aussparung der für die weiteren Gräben vorgesehen Zonen. Bei der ersten Variante werden die weiteren Gräben durch die zunächst geschlossene Schicht für die Kontaktelemente hindurch ausgehoben.

Vorteilhafte Weiterbildungen des erfindungsgemäßen Verfahrens sind in den Unteransprüchen enthalten.

Anschließend wird die Erfindung in zwei Ausführungsbeispielen anhand der Abbildungen näher beschrieben. Es zeigen in schematischer Weise:

Fig. 1 bis Fig. 6 eine erste Variante des erfindungsgemäßen Verfahrens unter Anwendung eines Maskierungsverfahrens bei der Aufbringung der schichtförmigen Kontaktelemente,

Fig. 7 bis Fig. 9 eine zweite Variante des erfindungsgemäßen Verfahrens, wobei die Kontaktelemente zunächst als durchgehende Schicht großflächig abgeschieden werden.

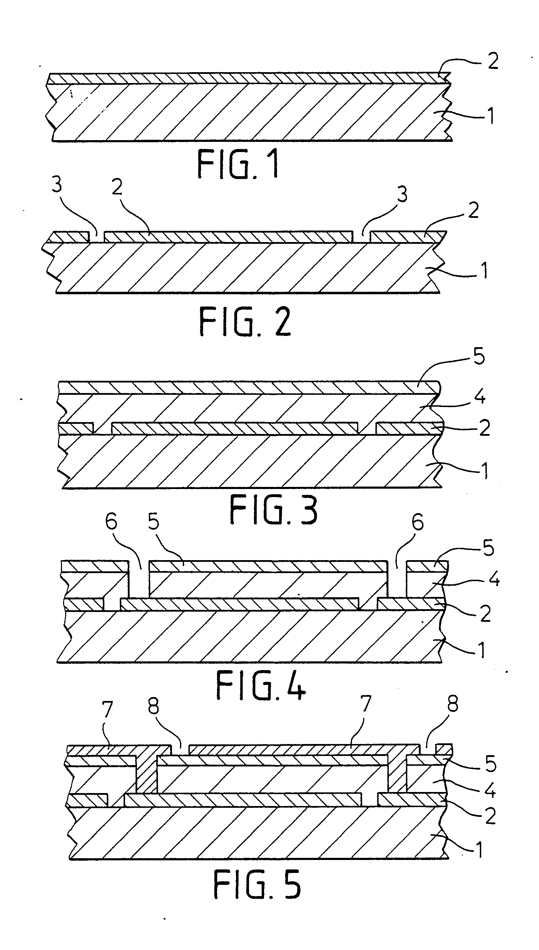

Fig. 1 zeigt im Querschnitt ein transparentes Substrat 1, beispielsweise aus Glas bestehend. Auf diesem ist ganzflächig eine transparente, erste Elektrodenschicht 2 aufgebracht, welche beispielsweise aus einem transparenten leitenden Oxid (TCO) besteht, etwa Indiumoxid, Zinnoxid oder Indiumzinnoxid (ITO). Die Beschichtung kann beispielsweise durch reaktives Sputtern oder Aufdampfen erfolgen. Die erste Elektrodenschicht 2 wird anschließend gemäß Fig. 2 in gewissen Bereichen 3 (erste Gräben) wieder entfernt, wodurch bereits die Aufteilung in einzelne Solarzellen vorgegeben ist. Die ersten Gräben 3 verlaufen vorzugsweise parallel und in regelmäßigen Abständen. Diese Strukturierung kann durch Laserstrahl, Elektroerosion oder andere einschlägige Verfahren, beispielsweise durch Photolithographie, erfolgen.

Hierauf (Fig. 3) direkt nacheinander zwei Schichten großflächig abgeschieden, und zwar eine Halbleiterschicht 4 sowie eine zweite Elektrodenschicht 5. Die Halbleiterschicht 4 kann beispielsweise aus amorphem Silizium, aber auch aus amorphem Germanium, Legierungen hieraus, auch mit Beimengungen von Wasserstoff, Halogen oder Kohlenstoff, oder aus anderen einschlägigen Materialien bestehen, welche geeignet sind, durch Absorption einfallender elektromagnetischer Strahlung, insbesondere von Licht, getrennte elektrische Ladungen zu erzeugen. Im Falle amorphen Siliziums kann die Halbleiterschicht 4 beispielsweise eine pin-Struktur aufweisen. Als gängiges Verfahren zum Abscheiden der Halbleiterschicht sei das Glimmentladungsverfahren genannt, es kommen aber auch andere, im Vakuum durchzuführende Verfahren infrage, beispielsweise die chemische oder thermische Zersetzung siliziumhaltiger Verbindungen in der Gasphase.

Die zweite Elektrodenschicht 5 wird unmittelbar nach der Halbleiterschicht 4 ebenfalls im Vakuum großflächig abgeschieden, z.B. durch Sputtern oder Aufdampfen von Aluminium, Silber, Nickel, Aluminium-Silizium-Legierungen, als Einzel-oder Mehrfachschichten.

Gemäß Fig. 4 werden in seitlicher Versetzung zu den ersten Gräben 3 und parallel zu diesen zweite Gräben 6 ausgehoben, welche bis auf die Oberfläche der verbleibenden Flächenbereiche der ersten Elektrodenschicht (2) herabreichen. Diese zweiten Gräben 6 durchtrennen sowohl die zweite Elektrodenschicht 5 als auch die Halbleiterschicht 4. Die Erzeugung der Gräben 6 kann mittels Ultraschallschneidwerkzeug oder durch Laserstrahl erfolgen. Diese Werkzeuge können in drei Dimensionen äußerst genau gesteuert werden. Durch die Abtragung hervorgerufene Kurzschlüsse zwischen zweiter und erster Elektrodenschicht 5 bzw. 2 im Randbereich der Gräben 6 sind nicht schädlich, insofern sind die Genauigkeitsanforderungen begrenzt. Wichtig ist lediglich, daß am Grund der zweiten Gräben 6 die erste Elektrodenschicht 2 freigelegt wird.

Fig. 5 zeigt eine Variante der Aufbringung der Kontaktelemente. Mittels einer Maskierungstechnik werden Kontaktelemente 7 flächen-bzw. schichtförmig aufgebracht, und zwar so, daß die zweiten Gräben 6 vollständig ausgefüllt werden und in seitlicher Versetzung zu diesen parallele, streifenförmige Zonen 8 freibleiben. Das Material der Kontaktelemente 7 muß in erster Linie elektrisch leitfähig sein. Im vorliegenden Ausführungsbeispiel wird eine leitfähige Metall-oder Graphitpaste gewählt. Diese kann beispielsweise durch Siebdruck aufgebracht werden.

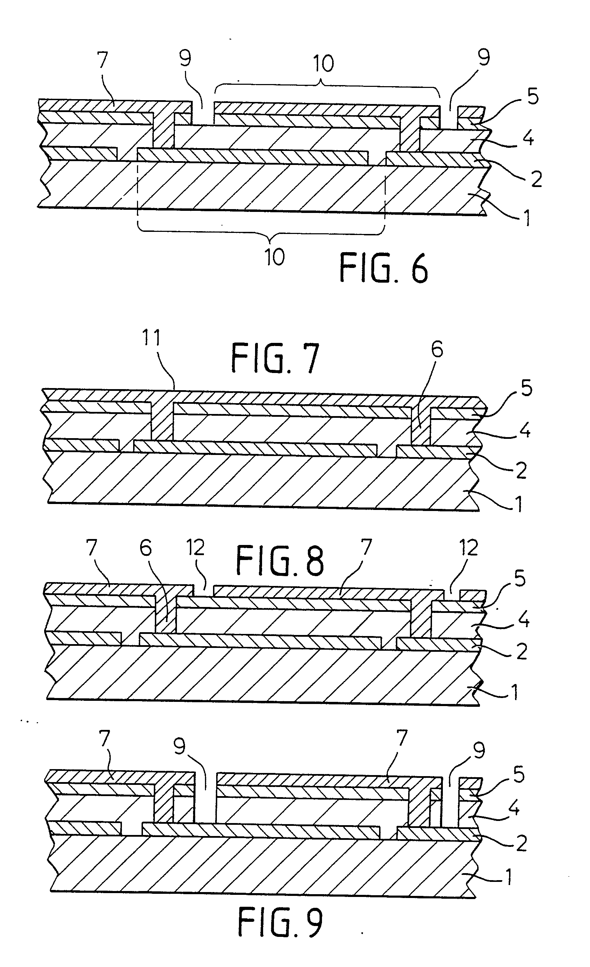

Gemäß Fig. 6 werden schließlich, ausgehend von den freigebliebenen Bereichen 8, weitere Gräben 9 ausgehoben, welche mindestens bis zur Oberfläche der Halbleiterschicht 4 herabreichen. Diese weiteren Gräben 9 können beispielsweise durch Ätzen erzeugt werden. Hierbei wirken die bereits durch die freien Bereiche 8 voneinander getrennt aufgebrachten Kontaktelemente 7 als Ätzmaske. In diesem Falle empfiehlt sich die Verwendung einer Graphitpaste für die Kontaktelemente 7, da diese Paste gegen Ätzmittel für die metallische zweite Elektrodenschicht 5 resistent ist. Durch diese Verfahrensweise ist der durch Auffüllung der zweiten Gräben 6 mit dem Material der Kontaktelemente 7 hergestellte Kurzschluß zwischen den ersten und zweiten Elektrodenschichten 2 und 5 wieder aufgehoben (weitere Gräben 9), und somit die Reihenverschaltung der einzelnen Solarzellen 10 vollendet. Beim Erzeugen der weiteren Gräben 9 spielt es ersichtlich keine Rolle, ob an deren Rändern Material der Kontaktelemente 7 die darunter liegenden Randbereich der zweiten Elektrodenschicht 5 etwas überlappt. Es muß lediglich sichergestellt sein, daß der Boden der weiteren Gräben 9 von leitendem Material freigehalten wird.

Fig. 7 stellt eine zweite Variante des Aufbringens der Kontaktelemente dar. Denmach wird nach Abscheidung und Strukturierung (zweite Gräben 6) der Halbleiterschicht 4 sowie der zeiten Elektrodenschicht 5 großflächig eine elektrisch leitende Schicht 11 aufgebracht. Auch hierbei kann es sich um eine Metall-oder Graphitpaste handeln, welche beispielsweise durch Siebdruck (ohne Maske) Sprühen, Bestreichen o.ä. schichtförmig abgelagert wird. Anschließend (Fig. 8) werden streifenförmige Bereiche 12 in seitlicher Versetzung zu den zweiten Gräben 6 und parallel zu diesen freigelegt, wodurch getrennte Kontaktelemente 7 entstehen. Diese freien Bereiche 12 werden mit - einem "weichen" Werkzeug, z.B. aus Aluminium, gebildet, ohne daß dabei die metallische zweite Elektrodenschicht 5 beschädigt wird. Bei dieser Variante können somit sämtliche Gräben 3, 6 sowie die freien Bereiche 12 etwa mit CNC-gesteuerten Bearbeitungsmaschinen erzeugt werden. Dadurch wird eine gewisse Homogenität des Verfahrensablaufs erreicht, was produktionstechnisch von Vorteil ist. Die Graphitpaste wird bei Temperaturen unter 120 °C ausgehärtet. Gemäß Fig. 9 können anschließend die weiteren Gräben 9, beispielsweise durch Ätzen, ausgehoben werden, im vorliegenden Ausführungsbeispiel auch bis zur Oberfläche der ersten Elektrodenschicht 2 hinab. Hierbei werden entweder zwei verschiedene Ätzmittel verwendet, oder nur eines, welches sowohl die metallische zweite Elektrodenschicht 5 als auch die Halbleiterschicht 4 herauslösen kann.

## Ansprüche

1. Verfahren zur Herstellung einer Solarzellenanordnung in Reihenschaltung und integrierter Dünnschichttechnik, bei dem auf einem transparenten Substrat eine erste, mindestens semitransparente Elektrodenschicht großflächig aufgebracht sowie anschließend in bestimmten Bereichen (erste Gräben) wieder abgetragen, sodann auf dieser eine zur Umwandlung einfallender elektromagnetischer Strahlung in elektrische Energie geeignet strukturierte Halbleiterschicht großflächig abgeschieden und darauf im weiteren Verfahrensablauf eine zweite Elektrodenschicht großflächig aufgebracht wird, wonach letztere und die Halbleiterschicht in dem Muster der abgetragenen Bereiche der ersten Elektrodenschicht in seitlicher Versetzung folgenden, separaten Bereichen (zweite Gräben) wieder abgetragen werden, und bei dem der Reihenverschaltung der einzelnen Solarzellen dienende Kontaktelemente angebracht werden, **dadurch gekennzeichnet,** daß die zweite Elektrodenschicht (5) unmittelbar nach der Halbleiterschicht (4) aufgebracht wird und die Kontaktelemente (7) auf den nach Erzeugung der zweiten Gräben (6) verbliebenen Flächenbereichen der zweiten Elektrodenschicht (5) unter Ausfüllung der zweiten Gräben (6) schichtförmig aufgebracht und neben den zweiten Gräben (6) im wesentlichen parallel zu diesen mindestens bis zur Oberfläche der Halbleiterschicht (4) hinabreichende, die schichtförmigen Kontaktelemente (7) voneinander separierende, weitere Gräben (9) eingebracht werden.

2. Verfahren nach Anspruch 1, **dadurch gekennzeichnet,** daß die zweiten Gräben (6) in einem Schritt, beispielsweise durch Ultraschall-oder Laseranwendung, ausgehoben werden.

3. Verfahren nach einem der Ansprüche 1 oder 2, **dadurch gekennzeichnet,** daß als Material der Kontaktelemente (7) eine leitfähige Paste, beispielsweise eine Graphit-oder Metallpaste, gewählt wird.

4. Verfahren nach einem der vorhergehenden Ansprüche, **dadurch gekennzeichnet,** daß zur Aufbringung der Kontaktelemente (7) zunächst eine durchgehende elektrisch leitende Schicht (11) großflächig abgeschieden und anschließend in den für die weiteren Gräben (9) vorgesehenen Zonen (12) wieder entfernt wird.

5. Verfahren nach einem der vorhergehenden Ansprüche, **dadurch gekennzeichnet,** daß die Kontaktelemente mittels einer Maskierungstechnik bereits in separaten Flächenbereichen unter Aussparung (8) der für die weiteren Gräben (9) vorgesehenen Zonen aufgebracht werden.

6. Verfahren nach Anspruch 5, **dadurch gekennzeichnet,** daß als Maskierungstechnik ein Siebdruckverfahren angewendet wird.

7. Verfahren nach einem der Ansprüche 4 bis 6, **dadurch gekennzeichnet,** daß die bereits in separaten Flächenbereichen vorhandenen Kontaktelemente (7) als Ätzmaske für die Einbringung der weiteren Gräben (9) durch Ätzen verwendet werden.

FIG. 1

FIG. 2

FIG. 3

FIG. 4

FIG. 5

10 254

FIG. 6

FIG. 7

FIG. 8

FIG. 9

10 254